(19) Europäisches Patentamt
European Patent Office
Office européen des brevets

(11) **EP 4 787 433 A1**

(12) **EUROPÄISCHE PATENTANMELDUNG**

(43) Veröffentlichungstag:
**05.08.2026 Patentblatt 2026/32**

(21) Anmeldenummer: **25155319.4**

(22) Anmeldetag: **31.01.2025**

(51) Internationale Patentklassifikation (IPC):
**H01L 23/00** (2006.01)  **B32B 15/20** (2006.01)
**H01L 23/373** (2006.01)

(52) Gemeinsame Patentklassifikation (CPC):
**H10W 72/30;** B32B 15/20; H10W 40/255;
H10W 72/013; H10W 72/07331; H10W 72/5525;
H10W 72/59; H10W 72/952; H10W 90/754

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(71) Anmelder: **Heraeus Electronics GmbH & Co. KG 63450 Hanau (DE)**

(72) Erfinder:
• **Krüger, Frank**
**63450 Hanau (DE)**
• **Klein, Andreas Steffen**
**63450 Hanau (DE)**
• **Hinrich, Andreas**
**63450 Hanau (DE)**

(74) Vertreter: **Heraeus IP**
**Heraeus Business Solutions GmbH**
**Intellectual Property**
**Heraeusstraße 12-14**
**63450 Hanau (DE)**

(54) **SUBSTRATANORDNUNG, VERFAHREN ZUR HERSTELLUNG EINER ELEKTRONISCHEN BAUGRUPPE UND ELEKTRONISCHE BAUGRUPPE**

(57) Die Erfindung betrifft eine Substratanordung, ein Verfahren zur Herstellung einer elektonischen Baugruppe und eletronische Baugruppe.

Die Substratanordnung weist auf: (a) eine Metallfolie, die eine Metallfolienoberseite und eine Metallfolienunterseite umfasst, wobei die Metallfolie eine Kupferschicht umfasst, die eine Kupferschichtoberseite und eine Kupferschichtunterseite aufweist, und wobei die Metallfolienoberseite von der Kupferschichtoberseite gebildet ist, und (b) eine Kontaktierungsschicht, die auf der Metallfolienunterseite angeordnet ist, dadurch gekennzeichnet, dass die Kupferschicht Metallfolie die Bedingung $K1 / D = 0{,}04 - 0{,}2\ \mu m^{-1}$ erfüllt, wobei D in einem Querschnitt durch die Substratanordnung senkrecht zur Kupferschichtoberseite den Abstand zwischen der Kupferschichtoberseite und der Kupferschichtunterseite angibt, und K1 die Anzahl an Korngrenzen angibt, die in einem Querschnitt durch die Substratanordnung senkrecht zur Kupferschichtoberseite entlang einer Strecke S1, die in dem Querschnitt senkrecht zur Kupferschichtoberseite von der Kupferschichtoberseite bis zur Kupferschichtunterseite verläuft, vorhanden sind.

Figur 1

**Beschreibung**

Die vorliegende Erfindung betrifft eine Substratanordnung, ein Verfahren zur Herstellung einer elektronischen Baugruppe und eine elektronische Baugruppe.

Zur Herstellung von elektronischen Baugruppen werden in der Leistungselektronik häufig Grundsubstrate, insbesondere Metall-Keramik-Substrate oder Leadframes, mit Elektronikbauteilen, insbesondere Halbleiterbauelementen, bestückt.

Auf der Oberseite der Elektronikbauteile, die den Grundsubstraten abgewandt ist, befinden sich Bereiche, die mit unbestückten Bereichen der Grundsubstrate elektrisch leitend kontaktiert werden müssen. Diese Kontaktierung erfolgt üblicherweise mit Bonddrähten, wobei ein Ende des Bonddrahts stoffschlüssig mit einem Bereich auf der Oberseite des Elektronikbauteils verbunden wird, während das andere Ende des Bonddrahts stoffschlüssig mit einem unbestückten Bereich des Grundsubstrats verbunden wird. Bonddrähte aus Aluminium können mit dem Metall der Grundsubstrate, insbesondere Kupfer, stoffschlüssig verbunden werden. Auch mit den Elektronikbauteilen lassen sich Bonddrähte aus Aluminium, zum Beispiel über eine metallische, zumeist silberhaltige Schicht, die sich auf der Oberseite der Elektronikbauteile befindet, stoffschlüssig verbinden. Bonddrähte aus Aluminium weisen allerdings den Nachteil einer geringen elektrischen Leitfähigkeit auf. Ferner hat sich herausgestellt, dass eine elektrische Kontaktierung von Elektronikbauteilen und Grundsubstraten über Bonddrähte aus Aluminium eine nur unzureichende Zuverlässigkeit und verminderte Funktionsfähigkeit aufweisen.

Aus diesem Grund gibt es den Bedarf, Bonddrähte aus Aluminium durch Bonddrähte aus Kupfer zu ersetzen. Kupfer weist im Vergleich zu Aluminium eine sehr hohe elektrische Leitfähigkeit auf. Darüber hinaus lassen sich Bonddrähte aus Kupfer mit dem Metall der Grundsubstrate, insbesondere Kupfer, besonders zuverlässig stoffschlüssig verbinden. Allerdings können Bonddrähte aus Kupfer nicht ohne weiteres stoffschlüssig mit der Oberseite der Elektronikbauteile verbunden werden.

Im Stand der Technik wird daher vorgeschlagen, Bonddrähte aus Kupfer nicht direkt mit der Oberseite der Elektronikbauteile zu verbinden. Vielmehr wird eine Substratanordnung bereitgestellt, die eine Metallfolie und eine Kontaktierungsschicht (zum Beispiel eine vorgetrocknete Sinterpaste) aufweist. Die Metallfolie, weist eine Oberseite und eine Unterseite auf, wobei die Unterseite der Metallfolie mit der Kontaktierungsschicht flächig verbunden ist. Die Metallfolie der Substratanordnung wird schließlich über die Kontaktierungsschicht mit der Oberseite des Elektronikbauteils stoffschlüssig verbunden, so dass die Oberseite der Metallfolie für eine stoffschlüssige Verbindung mit dem Kupferbonddraht zur Verfügung steht.

Elektronische Baugruppen sind im Betrieb üblicherweise starken Temperaturwechseln unter Strombelastung dauerhaft ausgesetzt. Unter der Einwirkung hoher Stromstärken kommt es dabei im Wechsel zu einer starken Aufheizung bei anschließender Abkühlung des Elektronikbauteils. Durch diese dauerhaften Temperaturwechsel unter Strombelastung wird insbesondere die über die Kontaktierungsschicht geschaffene Verbindung zwischen der Oberseite des Elektronikbauteils und der Unterseite der Metallfolie stark beansprucht, so dass dort oft Defekte auftreten. Es besteht daher Bedarf an einer Substratanordnung mit einer Metallfolie, deren Unterseite mit der Oberseite eines Elektronikbauteils eine Verbindung eingehen kann, die starken Temperaturwechseln unter Strombelastung dauerhaft standhalten kann.

Daher besteht eine Aufgabe der vorliegenden Erfindung vorzugsweise darin, eine Substratanordnung mit einer Metallfolie bereitzustellen, deren Unterseite mit der Oberseite eines Elektronikbauteils eine Verbindung eingehen kann, die starken Temperaturwechseln unter Strombelastung dauerhaft standhalten kann.

Eine weitere Aufgabe der vorliegenden Erfindung besteht vorzugsweise darin, eine Substratanordnung mit einer Metallfolie bereitzustellen, deren Oberseite mit einem Kupferbonddraht besonders schonend und dennoch stabil und mit gleichmäßig hoher Qualität verbindbar ist.

Diese Aufgaben werden gelöst durch die Substratanordnung gemäß Anspruch 1.

Die Erfindung stellt daher eine Substratanordnung bereit, aufweisend

(a) eine Metallfolie, die eine Metallfolienoberseite und eine Metallfolienunterseite umfasst,

wobei die Metallfolie eine Kupferschicht umfasst, die eine Kupferschichtoberseite und eine Kupferschichtunterseite aufweist, und
wobei die Metallfolienoberseite von der Kupferschichtoberseite gebildet ist, und

(b) eine Kontaktierungsschicht, die auf der Metallfolienunterseite angeordnet ist,

wobei die Kupferschicht die Bedingung

$$K1 / D = 0{,}04 - 0{,}2 \ \mu m^{-1}$$

erfüllt, wobei

D in einem Querschnitt durch die Substratanordnung senkrecht zur Kupferschichtoberseite den Abstand zwischen der Kupferschichtoberseite und der Kupferschichtunterseite angibt, und

K1 die Anzahl an Korngrenzen angibt, die in einem Querschnitt durch die Substratanordnung senkrecht zur Kupferschichtoberseite entlang einer Strecke S1, die in dem Querschnitt senkrecht zur Kupferschichtoberseite von der Kupferschichtoberseite bis zur Kupferschichtunterseite verläuft, vorhanden sind.

Ferner stellt die Erfindung ein Verfahren zur Herstellung einer elektronischen Baugruppe und eine elektronische Baugruppe bereit.

Die Erfindung betrifft eine Substratanordnung.

Mit der Substratanordnung kann vorzugsweise die elektrische Kontaktierung der Oberseite eines Elektronikbauteils mit unbestückten Bereichen von Grundsubstraten vorbereitet werden. Hierzu wird die Metallfolie über die Kontaktierungsschicht mit der Oberseite des Elektronikbauteils stoffschlüssig verbunden. Die Metallfolie stellt dabei eine Oberfläche bereit, die für die Ausbildung einer zuverlässigen stoffschlüssigen Verbindung mit einem Ende eines Bonddrahtes, insbesondere eines Kupferbonddrahtes, geeignet ist. Das andere Ende des Bonddrahtes kann mit einem unbestückten Bereich eines Grundsubstrats verbunden werden, so dass eine elektrische Kontaktierung zwischen der Oberseite des Elektronikbauteils und einem unbestückten Bereich eines Grundsubstrats über die Metallfolie und den Bonddraht resultiert.

Die Substratanordnung weist eine Metallfolie auf.

Die Metallfolie umfasst eine Metallfolienoberseite und eine Metallfolienunterseite. Auf der Metallfolienunterseite ist eine Kontaktierungsschicht angeordnet. Dabei ist die Metallfolienunterseite mit der Kontaktierungsschicht vorzugsweise wenigstens bereichsweise flächig verbunden. Die Metallfolienunterseite ist daher vorzugsweise die Fläche der Metallfolie mit dem größten Flächeninhalt, die mit der Kontaktierungsschicht wenigstens bereichsweise flächig verbunden ist. Daher ist die Metallfolienoberseite vorzugsweise die der Kontaktierungsschicht abgewandte Seite der Metallfolie. Die Metallfolienoberseite ist folglich die der Metallfolienunterseite abgewandte Seite.

Gemäß einer bevorzugten Ausführungsform ist die Metallfolienoberseite nicht stoffschlüssig mit einem Festkörper verbunden. Ein Festkörper ist vorzugsweise ein Körper, der bei einer Temperatur von 25°C und Normaldruck fest ist. Vorzugsweise ist die Metallfolienoberseite nicht stoffschlüssig mit einer Schicht aus isolierendem Material verbunden. Besonders bevorzugt ist die Metallfolienoberseite nicht stoffschlüssig mit einer Keramikschicht verbunden.

Gemäß einer weiteren bevorzugten Ausführungsform sind weniger als 20 Prozent, mehr bevorzugt weniger als 10 Prozent, noch mehr bevorzugt weniger als 5 Prozent, ganz besonders bevorzugt weniger als 1 Prozent und insbesondere weniger als 0,1 Prozent der Metallfolienoberseite, bezogen auf die Gesamtfläche der Metallfolienoberseite, mit einem Festkörper unlösbar verbunden. Unlösbar verbunden bedeutet vorzugsweise, dass eine Lösung der Verbindung nicht möglich ist oder eine wenigstens teilweise Zerstörung der Metallfolienoberseite, zumindest aber eine Funktionsbeeinträchtigung, zur Folge hätte. Bei dem Festkörper kann es sich um einen Festkörper umfassend isolierendes Material, insbesondere um einen Keramikkörper, handeln.

Gemäß einer weiteren bevorzugten Ausführungsform ist die Metallfolienoberseite mit einem Bonddraht, vorzugsweise einem Bonddraht, der wenigstens 50 Gewichtsprozent Kupfer umfasst, verbindbar.

Die Metallfolie weist vorzugsweise eine Dicke $d(Me)$ auf. Die Dicke $d(Me)$ der Metallfolie liegt vorzugsweise im Bereich von 5 - 500 $\mu$m, besonders bevorzugt im Bereich von 10 - 200 $\mu$m und ganz besonders bevorzugt im Bereich von 20 - 150 $\mu$m.

Die Metallfolie umfasst eine Kupferschicht.

Die Kupferschicht ist vorzugsweise von einer Kupferfolie gebildet. Die Kupferschicht weist vorzugsweise wenigstens 99,5 Gewichtsprozent Kupfer, besonders bevorzugt wenigstens 99,95 Gewichtsprozent Kupfer und ganz besonders bevorzugt wenigstens 99,995 Gewichtsprozent Kupfer, bezogen auf das Gesamtgewicht der Kupferschicht, auf.

Die Kupferschicht weist eine Kupferschichtoberseite und eine Kupferschichtunterseite auf. Die Metallfolienoberseite ist von der Kupferschichtoberseite gebildet. Die Kupferschichtunterseite kann mit einer weiteren Schicht verbunden sein.

Die Metallfolie kann aus der Kupferschicht bestehen. In diesem Fall kann die Metallfolienunterseite von der Kupferschichtunterseite gebildet sein.

Die Kupferschicht erfüllt die Bedingung: $K1 / D = 0,04 - 0,2\ \mu\text{m}^{-1}$. Die Kupferschicht erfüllt vorzugsweise die Bedingung: $K1 / D = 0,05 - 0,2\ \mu\text{m}^{-1}$, besonders bevorzugt die Bedingung: $K1 / D = 0,06 - 0,2\ \mu\text{m}^{-1}$ und ganz besonders bevorzugt die Bedingung: $K1 / D = 0,07 - 0,18\ \mu\text{m}^{-1}$.

D gibt in einem Querschnitt durch die Substratanordnung senkrecht zur Kupferschichtoberseite den Abstand zwischen der Kupferschichtoberseite und der Kupferschichtunterseite an.

K1 gibt die Anzahl an Korngrenzen an, die in einem Querschnitt durch die Substratanordnung senkrecht zur Kupferschichtoberseite entlang einer Strecke S1, die in dem Querschnitt senkrecht zur Kupferschichtoberseite von der Kupferschichtoberseite bis zur Kupferschichtunterseite verläuft, vorhanden sind.

Der Abstand D in einem Querschnitt durch die Substratanordnung senkrecht zur Kupferschichtoberseite zwischen der Kupferschichtoberseite und der Kupferschichtunterseite liegt vorzugsweise im Bereich von 5 - 500 $\mu$m, besonders bevorzugt im Bereich von 10 - 200 $\mu$m und ganz besonders bevorzugt im Bereich von 20 - 150 $\mu$m.

Die Strecke S1 weist vorzugsweise eine Länge auf, die dem Abstand D entspricht.

Die Anzahl an Korngrenzen K1, die in einem Querschnitt durch die Substratanordnung senkrecht zur Kupferschichtoberseite entlang einer Strecke S1, die in dem Querschnitt senkrecht zur Kupferschichtoberseite von der Kupferschichtoberseite bis zur Kupferschichtunterseite verläuft, vorhanden sind, liegt vorzugsweise im Bereich von 2 - 15, besonders bevorzugt im Bereich von 2 - 12 und ganz besonders bevorzugt im Bereich von 2 - 10.

Gemäß einer bevorzugten Ausführungsform erfüllt die Kupferschicht die Bedingung

$$K1 / K2 = 0{,}5 - 2{,}0.$$

Die Kupferschicht erfüllt mehr bevorzugt die Bedingung: K1 / K2 = 0,5 - 1,8, besonders bevorzugt die Bedingung: K1 / K2 = 0,6 - 1,8 und ganz besonders bevorzugt die Bedingung: K1 / K2 = 0,6 - 1,7.

K2 gibt die Anzahl an Korngrenzen an, die in dem Querschnitt (durch die Substratanordnung senkrecht zur Kupferschichtoberseite) entlang einer Strecke S2 vorhanden sind, wobei die Strecken S1 und S2 dieselbe Länge aufweisen, die Strecken S1 und S2 zueinander senkrecht verlaufen und die Strecke S2 die Strecke S1 auf halber Länge schneidet.

Die Anzahl an Korngrenzen K2, die in dem Querschnitt (durch die Substratanordnung senkrecht zur Kupferschichtoberseite) entlang einer Strecke S2 vorhanden sind, wobei die Strecken S1 und S2 dieselbe Länge aufweisen, die Strecken S1 und S2 zueinander senkrecht verlaufen und die Strecke S2 die Strecke S1 auf halber Länge schneidet, liegt vorzugsweise im Bereich von 2 - 30, besonders bevorzugt im Bereich von 2 - 8 und ganz besonders bevorzugt im Bereich von 2-5.

Der Begriff Korngrenzen umfasst vorzugsweise (i) die Grenzen zwischen benachbarten Körnern unabhängig von deren chemischer Zusammensetzung, (ii) Zwillingskorngrenzen und (iii) die Grenzen zwischen einem Kristall und einem weiteren Körper. Bei dem weiteren Körper kann es sich beispielsweise um einen gasgefüllten Körper (wie zum Beispiel eine Pore) handeln. Ferner kann es sich bei dem weiteren Körper um ein Objekt handeln, das zur Präparation des Querschnitts erforderlich ist (zum Beispiel einen Teil einer Einbettungsmatrix).

Die Werte D, K1 und K2 werden an einem Querschnitt durch die Substratanordnung senkrecht zur Kupferschichtoberseite bestimmt.

Die Präparation des Querschnitts und die Bestimmung der Werte D, K1 und K2 erfolgt vorzugsweise wie folgt: Zur Präparation des Querschnitts wird aus der zu untersuchenden Substratanordnung zunächst ein Probenrohling mit einer rechteckigen Grundfläche im Bereich von 100 mm$^2$ bis 400 mm$^2$ senkrecht zur Kupferschichtoberseite durch Sägen mit einem Diamantsägeblatt bei niedriger Drehzahl und unter Verwendung eines auf Öl basierenden Schmiermittels (Buehler, Illinois Tool Works Inc) ausgeschnitten. Der Probenrohling wird zunächst in einer Gussform mit einem Epoxidharz mit geringer Schrumpfung (Epo-Fix, Struers GmbH) eingebettet, wobei die Probenoberfläche senkrecht zur Formwand orientiert ist. Anschließend wird das Epoxidharz bei Raumtemperatur ausgehärtet. Nach der Aushärtung wird die Probenoberfläche des Probenrohlings mit einer automatisierten Poliervorrichtung (Tegrapol, Struers GmbH) mechanisch poliert, um eine Rauigkeit von 1 $\mu$m oder weniger zu erreichen. Anschließend erfolgt ein chemisch-mechanisches Polieren der Probenoberfläche unter Verwendung einer Poliersuspension (OP-S, Struers GmbH, mit einem Zusatz von Wasserstoffperoxid und Ammoniak).

Von dem so präparierten Querschnitt werden lichtmikroskopische Aufnahmen (DM8000 M, Leica) mit einer 200 - 500fachen Vergrößerung angefertigt. Die Werte für D, K1 und K2 werden vorzugsweise in einer lichtmikroskopischen Aufnahme des Querschnitts durch die Substratanordnung senkrecht zur Kupferschichtoberseite wie folgt bestimmt: Zur Bestimmung des Werts D wird in der lichtmikroskopischen Aufnahme der Abstand zwischen der Kupferschichtoberseite und der Kupferschichtunterseite bestimmt.

Zur Bestimmung des Werts K1 werden in der lichtmikroskopischen Aufnahme wenigstens zehn parallel zueinander verlaufende Strecken $S1_n$ angelegt, die in dem Querschnitt senkrecht zur Kupferschichtoberseite von der Kupferschichtoberseite bis zur Kupferschichtunterseite verlaufen. Die Korngrenzen, die von der jeder der Strecken $S1_n$ geschnitten werden, werden anschließend ausgezählt. Das arithmetische Mittel der Anzahl an Korngrenzen, die von jeder der Strecken $S1_n$ geschnitten werden, wird als Wert K1 bestimmt.

Zur Bestimmung des Werts K2 wird in der lichtmikroskopischen Aufnahme zu jeder Strecke $S1_n$ eine Strecke $S2_n$ angelegt, wobei die Strecke $S2_n$ dieselbe Länge aufweist wie die Strecke $S1_n$, die Strecke $S2_n$ und die Strecke $S1_n$ zueinander senkrecht verlaufen und die Strecke $S2_n$ die Strecke $S1_n$ auf halber Länge schneidet. Die Korngrenzen, die von der jeder der Strecken $S2_n$ geschnitten werden, werden anschließend ausgezählt. Das arithmetische Mittel der Anzahl an Korngrenzen, die von jeder der Strecken S2$_n$ geschnitten werden, wird als Wert K2 bestimmt.

Gemäß einer bevorzugten Ausführungsform umfasst die Metallfolie eine Haftvermittlungsschicht.

Die Haftvermittlungsschicht ist vorzugsweise eine Schicht, die eine Haftung der Kontaktierungsschicht auf der Metallfolienunterseite ermöglicht oder fördert. Die Haftvermittlungsschicht ist vorzugsweise eine Schicht, die die Ausbildung einer stoffschlüssigen Verbindung zwischen der Substratanordnung (insbesondere der Metallfolienunterseite der Substratanordnung) und der Oberseite eines Elektronikbauteils über die Kontaktierungsschicht ermöglicht oder fördert.

Die Haftvermittlungsschicht weist vorzugsweise eine Dicke im Bereich von 20 - 1500 nm, besonders bevorzugt eine Dicke im Bereich von 30 - 100 nm und ganz besonders bevorzugt eine Dicke im Bereich von 50 - 500 nm auf.

Die Haftvermittlungsschicht weist vorzugsweise eine Haftvermittlungsschichtoberseite und eine Haftvermittlungsschichtunterseite auf. Die Haftvermittlungsschichtoberseite ist vorzugsweise mit der Kupferschichtunterseite stoffschlüssig verbunden. Dabei ist die Haftvermittlungsschichtoberseite mit der Kupferschichtunterseite vorzugsweise flächig verbunden. Vorzugsweise ist die Kontaktierungsschicht auf der Haftvermittlungsschichtunterseite angeordnet.

Die Haftvermittlungsschicht umfasst vorzugsweise ein Edelmetall oder eine Edelmetalllegierung. Das Edelmetall ist vorzugsweise aus der Gruppe ausgewählt, die aus Gold, Silber und Palladium besteht. Die Edelmetalllegierung ist vorzugsweise eine Legierung, die wenigstens ein Edelmetall und wenigstens ein Nichtedelmetall enthält. Das Edelmetall der Edelmetalllegierung ist dabei vorzugsweise aus der Gruppe ausgewählt, die aus Gold, Silber und Palladium besteht. Das Nichtedelmetall der Edelmetalllegierung ist vorzugsweise Nickel. Die Edelmetalllegierung ist vorzugsweise aus der Gruppe ausgewählt, die aus Nickel-Gold-Legierungen, Nickel-Silber-Legierungen und Nickel-Palladium-Gold-Legierungen besteht.

Gemäß einer besonders bevorzugten Ausführungsform ist die Haftvermittlungsschicht mehrlagig ausgestaltet. Eine mehrlagige Ausgestaltung sieht zum Beispiel eine Nickellage, die mit der Kupferschichtunterseite in Kontakt steht, eine mit der Nickellage in Kontakt stehende Palladiumlage und eine mit der Palladiumlage in Kontakt stehende Goldlage vor.

Die Haftvermittlungsschicht kann zum Beispiel durch chemische (zum Beispiel elektrochemische) oder physikalische Abscheidung, insbesondere auf der Kupferschichtunterseite, geschaffen sein. Die chemische Abscheidung kann zum Beispiel galvanisch oder außenstromlos erfolgen.

Gemäß einer weiteren bevorzugten Ausführungsform weist die Metallfolie wenigstens eine Durchgangsöffnung auf. Unter Durchgangsöffnung ist vorzugsweise eine Ausnehmung im Material der Metallfolie zu verstehen, die sich von einer ersten Öffnung auf der Metallfolienoberseite bis zu einer zweiten Öffnung auf der Metallfolienunterseite erstreckt. Die Öffnungen können dabei unterschiedliche Größen und Geometrien aufweisen. Es kann bevorzugt sein, dass die Metallfolie mehrere Durchgangsöffnungen aufweist. Die Durchgangsöffnungen können beispielsweise zylindrisch, rund, rechteckig, oval, elliptisch oder rechteckig mit abgerundeten Ecken ausgestaltet sein. Die Gegenwart von Durchgangsöffnungen kann insbesondere dann vorteilhaft sein, wenn die Substratanordnung eine Vorfixierschicht umfasst, die ein Vorfixiermittel enthält. In diesem Fall können sich Anteile oder Reste des Vorfixiermittels bei einer Temperaturbeaufschlagung oder Druckbeaufschlagung, wie zum Beispiel bei einem Sintervorgang, verflüssigen und in die Durchgangsöffnungen aufgrund der durch die Durchgangsöffnung hervorgerufenen Kapillarwirkung aufgenommen werden, um dadurch ein unkontrollierbares Austreten der Anteile oder Reste des Vorfixiermittels zu vermeiden.

Die Substratanordnung weist eine Kontaktierungsschicht auf.

Die Kontaktierungsschicht ist vorzugsweise eine Schicht, die in der Lage ist, die Ausbildung einer stoffschlüssigen Verbindung zwischen der Oberseite eines Elektronikbauteils, insbesondere der gegebenenfalls metallisierten Oberseite eines Elektronikbauteils, und der Metallfolie, insbesondere der Metallfolienunterseite, zu ermöglichen oder zu befördern.

Die Kontaktierungsschicht ist auf der Metallfolienunterseite angeordnet. Vorzugsweise ist die Kontaktierungsschicht mit der Metallfolienunterseite flächig verbunden.

Die Kontaktierungsschicht weist vorzugsweise eine Dicke im Bereich von 5 - 500 $\mu$m, besonders bevorzugt eine Dicke im Bereich von 5 - 250 $\mu$m und ganz besonders bevorzugt eine Dicke im Bereich von 10 - 100 $\mu$m auf.

Die Kontaktierungsschicht umfasst ein Kontaktierungsmittel. Das Kontaktierungsmittel ist vorzugsweise in der Lage, mit der (gegebenenfalls metallisierten) Oberseite eines Elektronikbauteils eine stoffschlüssige Verbindung einzugehen.

Das Kontaktierungsmittel umfasst vorzugsweise wenigstens ein Mitglied, das aus der Gruppe ausgewählt ist, die aus Silber und Kupfer besteht.

Gemäß einer bevorzugten Ausführungsform umfasst das Kontaktierungsmittel wenigstens ein Element, das aus der Gruppe ausgewählt ist, die aus Sintermaterialien, Lotmaterialien und Klebstoffen besteht.

Das Sintermaterial ist vorzugsweise aus der Gruppe ausgewählt, die aus Sinterpasten, Sinterfolien und Sintervorformen besteht.

Gemäß einer bevorzugten Ausführungsform umfasst das Sintermaterial eine Sinterpaste. Bei der Sinterpaste handelt es sich vorzugsweise um eine fachübliche Sinterpaste. Vorzugsweise umfasst die Sinterpaste wenigstens ein Metall, das aus der Gruppe ausgewählt ist, die aus Silber und Kupfer besteht, und eine organische Verbindung. Es kann bevorzugt sein, dass das Metall in der Sinterpaste in Form von Partikeln vorliegt. Die Partikel können eine beliebige Form annehmen und daher beispielsweise als sphärische Partikel, Flakes oder unregelmäßig geformte Metallpartikel vorliegen. Die organische Verbindung ist vorzugsweise aus der Gruppe ausgewählt, die aus Dispersionsmitteln, Bindemitteln, Fettsäuren und Mischungen davon besteht. Die Dispersionsmittel können aus fachüblichen Dispersionsmitteln ausgewählt sein. Ein beispielhaftes Dispersionsmittel ist Terpineol. Die Bindemittel können aus fachüblichen Polymeren ausgewählt sein. Beispielhaft genannt seien Zellulosederivate, so zum Beispiel Methylzellulose, Ethylzellulose, Ethylmethylzellulose, Carboxyzellullose und Hydroxypropylzellulose. Die Fettsäuren können aus fachüblichen Fettsäuren ausgewählt sein. Vorzugsweise sind die Fettsäuren aus der Gruppe ausgewählt, die aus Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure) und Lignocerinsäure (Tetracosansäure) besteht.

Gemäß einer weiteren bevorzugten Ausführungsform umfasst das Sintermaterial eine Sinterfolie. Vorzugsweise handelt es sich bei der Sinterfolie um eine fachübliche Sinterfolie, wie sie zum Beispiel in der europäischen Patentanmeldung EP3154729 A1 offenbart ist. Eine Sinterfolie kann daher zum Beispiel eine Sinterpaste, die Metallpartikel (insbesondere Silberpartikel) und ein Bindemittel umfasst, aufweisen, die auf einem Trägersubstrat vorgetrocknet vorliegt. Die Sinterfolie kann zum Beispiel eine Dicke im Bereich von 5 - 300 $\mu$m aufweisen.

Gemäß einer weiteren bevorzugten Ausführungsform umfasst das Sintermaterial eine Sintervorform. Vorzugsweise handelt es sich bei der Sintervorform um eine fachübliche Sintervorform, wie sie zum Beispiel in der europäischen Patentanmeldung EP2428293 A2 offenbart ist.

Gemäß einer bevorzugten Ausführungsform umfasst das Lotmaterial eine Lotpaste. Bei der Lotpaste handelt es sich vorzugsweise um eine fachübliche Lotpaste. Die Lotpaste umfasst vorzugsweise eine Lotlegierung und ein Flussmittel. Die Lotlegierung umfasst vorzugsweise als Hauptelement (Element mit dem größten Gewichtsanteil) Zinn, besonders bevorzugt wenigstens ein weiteres Element, das aus der Gruppe ausgewählt ist, die aus Kupfer und Silber besteht, und ganz besonders bevorzugt wenigstens ein weiteres Element, das aus der Gruppe ausgewählt ist, die aus Bismut, Antimon, Indium, Germanium, Cobalt, Eisen und Nickel besteht. Das Flussmittel ist vorzugsweise ein fachübliches Flussmittel, besonders bevorzugt ein organisches Flussmittel.

Gemäß einer bevorzugten Ausführungsform umfasst der Klebstoff einen Leitkleber. Beim Leitkleber handelt es sich vorzugsweise um einen fachüblichen Leitkleber. Der Leitkleber umfasst vorzugsweise Silberpartikel und ein Epoxidharz, das besonders bevorzugt bei einer Temperatur im Bereich von 120°C - 200°C aushärtet.

Gemäß einer besonders bevorzugten Ausführungsform umfasst die Kontaktierungsschicht eine vorgetrocknete Sinterpaste.

Gemäß einer bevorzugten Ausführungsform umfasst die Substratanordnung eine Vorfixierschicht.

Die Vorfixierschicht ist vorzugsweise eine Schicht, die mit der Metallfolienunterseite und/oder der Kontaktierungsschicht verbunden ist. Die Metallfolienunterseite ist dabei vorzugsweise durch die Kupferfolienunterseite oder die Haftvermittlungsschicht gebildet. Bei der Vorfixierschicht kann es sich zum Beispiel um eine zusammenhängende Schicht oder um eine unterbrochene Schicht handeln. Die Dimension der zusammenhängenden Schicht ist nicht weiter eingeschränkt. Daher umfasst die zusammenhängende Schicht auch eine punktförmige Schicht. Im Fall einer zusammenhängenden Schicht kann die Vorfixierschicht mit der Metallfolienunterseite und/oder der Kontaktierungsschicht flächig verbunden sein. Im Fall einer unterbrochenen Schicht kann die Vorfixierschicht mehrere, zum Beispiel auch nicht miteinander in Kontakt stehende Abschnitte umfassen, die mit der Metallfolienunterseite und/oder der Kontaktierungsschicht flächig verbunden sind. Sofern die Vorfixierschicht mit der Metallfolienunterseite verbunden ist, ist die Kontaktierungsschicht mit der Metallfolienunterseite vorzugsweise bereichsweise flächig verbunden und die Vorfixierschicht ist mit Bereichen der Metallfolienunterseite verbunden, die nicht flächig mit der Kontaktierungsschicht verbunden sind. Dabei sind die Kontaktierungsschicht und die Vorfixierschicht jeweils mit der Metallfolienunterseite verbunden und vorzugsweise nebeneinander angeordnet.

Gemäß einer bevorzugten Ausführungsform ist die Vorfixierschicht als zusammenhängende Schicht ausgebildet und mit der Kontaktierungsschicht flächig verbunden, so dass wenigstens 20%, mehr bevorzugt wenigstens 50%, besonders bevorzugt wenigstens 70%, ganz besonders bevorzugt wenigstens 98% und insbesondere 100% der Kontaktierungsschicht mit der Vorfixierschicht in Kontakt stehen.

Gemäß einer weiteren bevorzugten Ausführungsform ist die Vorfixierschicht als zusammenhängende Schicht punktförmig ausgebildet und steht mit der Kontaktierungsschicht und/oder mit der Metallfolienunterseite in Kontakt.

Gemäß einer weiteren bevorzugten Ausführungsform ist die Vorfixierschicht als unterbrochene Schicht umfassend mehrere nicht miteinander in Kontakt stehende Abschnitte ausgebildet, die mit der Kontaktierungsschicht und/oder mit der Metallfolienunterseite in Kontakt stehen.

Die Vorfixierschicht umfasst vorzugsweise ein Vorfixiermittel. Das Vorfixiermittel kann zu einer Vorfixierung der Substratanordnung an einem Elektronikbauteil dienen, damit der Aufbau umfassend die Substratanordnung und das Elektronikbauteil eine verbesserte Transportfähigkeit - zum Beispiel zum Ort der Weiterverarbeitung - aufweist. Vorzugsweise ist das Vorfixiermittel ein temporäres oder lösbares Fixiermittel, das zumindest eine vorübergehende Fixierung der Substratanordnung mit einem Elektronikbauteil ermöglicht. Geeignete Vorfixiermittel sind zum Beispiel in der europäischen Patentanmeldung EP3940758 A2 beschrieben.

Das Vorfixiermittel umfasst daher vorzugsweise wenigstens eine Verbindung, die aus der Gruppe ausgewählt ist, die aus thermoplastischen Polymeren, anorganischen Füllstoffpartikeln und organischen Lösungsmitteln besteht. Gemäß einer bevorzugten Ausführungsform umfasst das Vorfixiermittel wenigstens ein thermoplastisches Polymer und besonders bevorzugt wenigstens eine Verbindung, die aus der Gruppe ausgewählt ist, die aus anorganischen Füllstoffpartikeln und organischen Lösungsmitteln besteht.

Die thermoplastischen Polymere weisen vorzugsweise eine Glasübergangstemperatur im Bereich von 60 - 120 °C auf. Die Bestimmung der Glasübergangstemperatur wird vorzugsweise mittels Dynamischer Differenzkalorimetrie (DKK) oder mittels Differential Scanning Calorimetry (DSC) bei einer Aufheizrate von 10 °C/Minute durchgeführt. Bei den thermoplastischen Polymeren kann es sich insbesondere um (Meth)acrylcopolymere handeln. Die (Meth)acrylcopolymere weisen vorzugsweise eine Molmasse im Bereich von 35.000 - 70.000 g/mol auf (Mw = 35.000 bis 70.000 g/mol). Die Molmasse wird vorzugsweise mittels Gelpermeationschromatographie (GPC) bestimmt. Für die Gelpermeationschromatographie gilt: Polystyrolgel als stationäre Phase, Tetrahydrofuran als mobile Phase, Polystyrolstandards.

Die anorganischen Füllstoffpartikel sind vorzugsweise Partikel umfassend wenigstens ein Element, das aus der Gruppe ausgewählt ist, die aus Aluminiumoxid, Siliziumdioxid, Titandioxid, Zirkonsilikat, Calciumsilikat, Glimmer, Kaolin und $\alpha$-Bornitrid besteht. Vorzugsweise weisen die anorganischen Füllstoffpartikel eine durchschnittliche Teilchengröße (d50) im Bereich von 5 - 20 $\mu$m und besonders bevorzugt im Bereich von 5 - 10 $\mu$m auf. Die Bestimmung der durchschnittlichen Teilchengröße (d50) erfolgt vorzugsweise mittels eines Laserbeugungsverfahrens.

Die organischen Lösungsmittel weisen vorzugsweise einen Siedepunkt von nicht mehr als 285°C auf. Gemäß einer bevorzugten Ausführungsform sind die organischen Lösungsmittel aus der Gruppe ausgewählt, die aus Aromaten, Ketonen, Estern, Glykolethern und Alkoholen besteht. Gemäß einer besonders bevorzugten Ausführungsform sind die organischen Lösungsmittel aus der Gruppe ausgewählt, die aus Toluol, Xylol, Methylethylketon, Methylisobutylketon, Polyvinylethern, Ethylacetat, Isobutylacetat, Bernsteinsäuredimethylester, Diethylenglykolmonobutylether, Benzylalkohol, Triphenylverbindungen, Dimethylverbindungen und Terpineolen besteht. Gemäß einer ganz besonders bevorzugten Ausführungsform sind die organischen Lösungsmittel aus der Gruppe der Terpineole ausgewählt.

Gemäß einer bevorzugten Ausführungsform ist die Substratanordnung zur Verbindung mit wenigstens einem Elektronikbauteil geeignet. Gemäß einer besonders bevorzugten Ausführungsform ist die Substratanordnung zur Verbindung der Metallfolie mit wenigstens einem Elektronikbauteil geeignet.

Unter Elektronikbauteil wird vorzugsweise ein elektronisches oder elektrisches Bauelement verstanden. Das Elektronikbauteil ist vorzugsweise aus der Gruppe ausgewählt, die aus Halbleiterbauelementen besteht. Die Halbleiterbauelemente sind vorzugsweise aus der Gruppe ausgewählt, die aus Transistoren, Dioden und integrierten Schaltkreisen besteht.

Gemäß einer bevorzugten Ausführungsform umfasst das Elektronikbauteil eine metallische Oberseitenbeschichtung. Die metallische Oberseitenbeschichtung kann dazu dienen, eine leichtere Anbindung der Metallfolie über die Kontaktierungsschicht an die Oberseite des Elektronikbauteils zu ermöglichen. Daher kann es bevorzugt sein, dass die Oberseite des Elektronikbauteils von der metallischen Oberseitenbeschichtung geschaffen wird. Vorzugsweise umfasst die metallische Oberseitenbeschichtung des Elektronikbauteils wenigstens ein Element, das aus der Gruppe ausgewählt ist, die aus Nickel, Palladium, Silber, Kupfer und Gold besteht. Gemäß einer bevorzugten Ausführungsform umfasst das Elektronikbauteil eine metallische Unterseitenbeschichtung. Die metallische Unterseitenbeschichtung kann dazu dienen, eine leichtere Anbindung des Grundsubstrats an die Unterseite des Elektronikbauteils zu ermöglichen. Daher kann es bevorzugt sein, dass die Unterseite des Elektronikbauteils von der metallischen Unterseitenbeschichtung geschaffen wird. Vorzugsweise umfasst die metallische Unterseitenbeschichtung des Elektronikbauteils wenigstens ein Edelmetall. Gemäß einer bevorzugten Ausführungsform umfasst die metallische Unterseitenbeschichtung des Elektronikbauteils wenigstens ein Element, das aus der Gruppe ausgewählt ist, die aus Gold, Silber, Aluminium, Titan und Nickel besteht, und ganz besonders bevorzugt Silber.

Mit der Substratanordnung kann vorzugsweise die elektrische Kontaktierung der Oberseite des Elektronikbauteils mit unbestückten Bereichen von Grundsubstraten vorbereitet werden. Hierzu wird die Metallfolie der Substratanordnung über die Kontaktierungsschicht mit der Oberseite des Elektronikbauteils stoffschlüssig verbunden. Die Metallfolie stellt dabei eine Oberfläche bereit, die für die stoffschlüssige Verbindung mit einem Bonddraht, insbesondere einem Kupferbonddraht, auf besonders stabile Weise und mit gleichmäßig hoher Qualität geeignet ist.

Überraschenderweise hat sich herausgestellt, dass eine Substratanordnung, die eine Metallfolie umfasst, die eine Kupferschicht aufweist, die die Bedingung K1 / D = 0,04 - 0,2 $\mu$m$^{-1}$ erfüllt, mit der Oberseite eines Elektronikbauteils eine Verbindung eingehen kann, die starken Temperaturwechseln unter Strombelastung dauerhaft standhalten kann, und gleichzeitig eine Oberseite bereitstellt, die mit einem Kupferbonddraht besonders schonend und dennoch stabil und mit gleichmäßig hoher Qualität verbindbar ist. Dieser Effekt ist überraschenderweise besonders stark ausgeprägt, wenn die Kupferschicht die Bedingung K1 / K2 = 0,5 - 2,0 erfüllt.

Das Verfahren zur Herstellung der erfindungsgemäßen Substratanordnung ist nicht weiter eingeschränkt.

Gemäß einer bevorzugten Ausführungsform umfasst das Verfahren zur Herstellung der erfindungsgemäßen Substratanordnung die Schritte:

(A) Bereitstellen einer Metallfolie, die eine Metallfolienoberseite und eine Metallfolienunterseite umfasst, wobei die Metallfolie eine Kupferschicht umfasst, die eine Kupferschichtoberseite und eine Kupferschichtunterseite aufweist, wobei die Metallfolienoberseite von der Kupferschichtoberseite gebildet ist, und wobei die Kupferschicht die Bedingung

$$K1 / D = 0,04 - 0,2 \ \mu m^{-1}$$

erfüllt, wobei

D in einem Querschnitt durch die Substratanordnung senkrecht zur Kupferschichtoberseite den Abstand zwischen der Kupferschichtoberseite und der Kupferschichtunterseite angibt, und

K1 die Anzahl an Korngrenzen angibt, die in einem Querschnitt durch die Substratanordnung senkrecht zur Kupferschichtoberseite entlang einer Strecke S1, die in dem Querschnitt senkrecht zur Kupferschichtoberseite von der Kupferschichtoberseite bis zur Kupferschichtunterseite verläuft, vorhanden sind,

(B) Bereitstellung eines Kontaktierungsmittels und

(C) Aufbringen des Kontaktierungsmittels auf der Metallfolienunterseite unter Ausbildung einer Kontaktierungsschicht.

In Schritt (A) des Verfahrens wird eine Metallfolie bereitgestellt, die eine Metallfolienoberseite und eine Metallfolienunterseite umfasst, wobei die Metallfolie eine Kupferschicht umfasst, die eine Kupferschichtoberseite und eine Kupferschichtunterseite aufweist, wobei die Metallfolienoberseite von der Kupferschichtoberseite gebildet ist, und wobei die Kupferschicht die Bedingung

$$K1 / D = 0,04 - 0,2 \ \mu m^{-1}$$

erfüllt, wobei

D in einem Querschnitt durch die Substratanordnung senkrecht zur Kupferschichtoberseite den Abstand zwischen der Kupferschichtoberseite und der Kupferschichtunterseite angibt, und

K1 die Anzahl an Korngrenzen angibt, die in einem Querschnitt durch die Substratanordnung senkrecht zur Kupferschichtoberseite entlang einer Strecke S1, die in dem Querschnitt senkrecht zur Kupferschichtoberseite von der Kupferschichtoberseite bis zur Kupferschichtunterseite verläuft, vorhanden sind.

Gemäß einer bevorzugten Ausführungsform wird in Schritt (A) des Verfahrens eine Metallfolie bereitgestellt, wobei die Kupferschicht die Bedingung

$$K1 / K2 = 0,5 - 2,0$$

erfüllt,

wobei K2 die Anzahl an Korngrenzen angibt, die in dem Querschnitt entlang einer Strecke S2 vorhanden sind, und

wobei die Strecken S1 und S2 dieselbe Länge aufweisen, die Strecken S1 und S2 zueinander senkrecht verlaufen und die Strecke S2 die Strecke S1 auf halber Länge schneidet.

Bei der Metallfolie handelt es sich vorzugsweise um eine wie hierin an anderer Stelle beschriebene Metallfolie.
Bei der Metallfolie kann es sich beispielsweise um eine Kupferfolie handeln, die eine Kupferschichtoberseite und eine Kupferschichtunterseite aufweist. Auf der Kupferschichtunterseite kann optional eine Haftvermittlungsschicht angeordnet sein, die eine Haftvermittlungsschichtoberseite und eine Haftvermittlungsschichtunterseite aufweist. Die Haftvermittlungsschichtoberseite kann dabei mit der Kupferschichtunterseite auf fachübliche Weise stoffschlüssig verbunden sein.

Die Metallfolie kann beispielsweise kommerziell erworben oder auf fachübliche Weise hergestellt werden. Die Kupferschicht der - zum Beispiel kommerziell erworbenen oder hergestellten - Metallfolie kann bereits die erforderliche oder bevorzugte Beschaffenheit im Hinblick auf das Verhältnis $K1 / D = 0,04 - 0,2$ µm$^{-1}$ und vorzugsweise das Verhältnis $K1 / K2 = 0,5 - 2,0$ aufweisen. Alternativ kann das Verhältnis $K1 / D = 0,04 - 0,2$ µm$^{-1}$ und vorzugsweise das Verhältnis $K1 / K2 = 0,5 - 2,0$ auf fachübliche Weise eingestellt werden.

Das Verhältnis $K1 / D$ und das Verhältnis $K1 / K2$ können unabhängig voneinander insbesondere durch ein Walzen der Metallfolie und eine Wärmebehandlung der Metallfolie eingestellt werden.

Durch ein Walzen der Metallfolie kann beispielsweise die Form der in der Kupferschicht enthaltenen Körner gezielt eingestellt werden. Dabei werden beim Walzen die Körner in der Kupferschicht entlang der Walzrichtung gesteckt, so dass sich der Wert K1 erhöht und der Wert K2 vermindert. Durch eine Wärmebehandlung der Metallfolie kommt es - in Abhängigkeit von der Behandlungstemperatur und der Behandlungsdauer - zu einer Rekristallisation der in der Kupferschicht enthaltenen Körner und zu einem Kornwachstum. Dabei erhalten gestreckte Körner eine zunehmend runde Form, so dass sich der Wert K1 vermindert und der Wert K2 erhöht.

So kann durch ein Walzen einer Metallfolie beispielsweise zunächst das Verhältnis $K1 / D$ in der Kupferschicht, zum Beispiel auch über den erfindungsgemäßen Wert hinaus, erhöht (da durch das Walzen langgestreckte Körner entstehen und sich so der Wert K1 erhöht und gleichzeitig die Dicke D erniedrigt wird) und anschließend durch eine Wärmebehandlung auf den anspruchsgemäßen Wert eingestellt werden (da durch die Wärmebehandlung der Wert K1 vermindert wird). Nach demselben Prinzip kann das Verhältnis $K1 / K2$ in der Kupferschicht auf den gewünschten Wert eingestellt werden.

Das Walzen der Metallfolie erfolgt vorzugsweise auf fachübliche Weise. Unter Walzen wird vorzugsweise ein Bearbeitungsverfahren verstanden, bei dem die Metallfolie zwischen zwei oder mehreren rotierenden Werkzeugen bearbeitet wird. Das Walzen kann sowohl als Warmwalzen als auch Kaltwalzen durchgeführt werden. Bevorzugt erfolgt das Walzen als Kaltwalzen. Gemäß einer bevorzugten Ausführungsform erfolgt das Walzen durch wenigstens eine Walze. Unter einer Walze wird vorzugsweise ein im Wesentlichen zylindrischer Körper verstanden. Die Walze kann grundsätzlich jeden beliebigen Durchmesser haben. Für den vorgesehenen Einsatzzweck eignen sich bevorzugt Walzen mit einem Durchmesser im Bereich von 50 - 150 mm. Ferner sollte die Walze aus einem Material gebildet sein, das unter Einsatzbedingungen härter ist als das Material der Metallfolie. Geeignete Walzen können daher zum Beispiel aus geschmiedetem Stahl, Hartmetall oder Stahlguss gebildet sein. Gemäß einer bevorzugten Ausführungsform erfolgt das Walzen mit einer Anordnung, die wenigstens eine Walze umfasst. Es sind auch Anordnungen mit mehreren Walzen, zum Beispiel zwei oder mehr Walzen, möglich. Geeignet ist zum Beispiel eine Anordnung, bei der wenigstens zwei Walzen gegenläufig rotieren und die Metallfolie zwischen den zwei gegenläufigen Walzen durchgeführt wird. Die zwei gegenläufigen Walzen sind so angeordnet, dass zwischen den beiden Walzen ein Abstand vorgesehen ist. Die Geometrie der Walze ist nicht weiter eingeschränkt. Das Walzen erfolgt vorzugsweise mit wenigstens einer Walze, die eine zylindrische Oberfläche aufweist.

Die Wärmebehandlung der Metallfolie erfolgt vorzugsweise auf fachübliche Weise. Wie vorstehend ausgeführt können die Bedingungen, zu denen die Wärmebehandlung erfolgt, insbesondere von der Beschaffenheit der Metallfolie abhängen, die der Wärmebehandlung unterzogen werden soll. So kann es beispielsweise erforderlich sein, eine stark gewalzte Metallfolie einer Wärmebehandlung bei einer höheren Behandlungstemperatur und/oder einer längeren Behandlungsdauer zu unterziehen als eine nicht gewalzte oder weniger stark gewalzte Metallfolie. Zum Beispiel kann es vorteilhaft sein, dass die Wärmebehandlung bei einer Behandlungstemperatur im Bereich von 275 - 500°C und für eine Behandlungsdauer im Bereich von 60 - 300 min durchgeführt wird. Die Wärmebehandlung kann dabei vorzugsweise in einer Prozessgasatmosphäre (zum Beispiel einem Gemisch aus 5 % Wasserstoff und 95 % Stickstoff) erfolgen.

In Schritt (B) des Verfahrens erfolgt die Bereitstellung eines Kontaktierungsmittels.

Bei dem Kontaktierungsmittel handelt es vorzugsweise um ein wie hierin an anderer Stelle beschriebenes Kontaktierungsmittel.

In Schritt (C) des Verfahrens erfolgt das Aufbringen des Kontaktierungsmittels auf der Metallfolienunterseite unter Ausbildung einer Kontaktierungsschicht.

Das Aufbringen des Kontaktierungsmaterials auf die Metallfolienunterseite unter Ausbildung einer Kontaktierungsschicht kann durch fachübliche Verfahren erfolgen. Vorzugsweise erfolgt das Aufbringen des Kontaktierungsmaterials durch Jetten, Dispensen, Sprühen, Pinseln, Tupfen, Tauchen oder Drucken, insbesondere Siebdrucken oder Schablonendrucken, oder durch Laminieren

Gemäß einer bevorzugten Ausführungsform erfolgt in einem weiteren Schritt (D) das Aufbringen eines Vorfixiermittels auf die Metallfolienunterseite und/oder die Kontaktierungsschicht unter Ausbildung einer Vorfixierschicht, wobei die Vorfixierschicht mit der Metallfolienunterseite und/oder der Kontaktierungsschicht wenigstens bereichsweise flächig verbunden ist. Bei dem Vorfixiermittel handelt es vorzugsweise um ein wie hierin an anderer Stelle beschriebenes Vorfixiermittel. Das Aufbringen des Vorfixiermittels auf die Metallfolienunterseite und/oder die Kontaktierungsschicht kann durch fachübliche Verfahren erfolgen. Vorzugsweise erfolgt das Aufbringen des Vorfixiermittels durch Jetten, Dispensen, Sprühen, Pinseln, Tupfen, Tauchen oder Drucken, insbesondere Siebdrucken oder Schablonendrucken.

Gemäß einer bevorzugten Ausführungsform erfolgt in einem weiteren Schritt (E) des Verfahrens eine Vortrocknung des Kontaktierungsmittels, besonders bevorzugt des Sintermaterials und ganz besonders bevorzugt der Sinterpaste. Die Vortrocknung kann dazu dienen, in dem Kontaktierungsmaterial enthaltene flüchtige Bestandteile, wie zum Beispiel organische Verbindungen, wenigstens teilweise zu entfernen. Das Vortrocknen kann zum Beispiel bei einer Temperatur im Bereich von 80 - 150°C und beispielsweise für einen Zeitraum von 2 - 30 Minuten erfolgen. Die Vortrocknung hat üblicherweise einen Volumenschwund zur Folge, so dass auch die Dicke der Kontaktierungsschicht reduziert wird.

Gemäß einer weiteren bevorzugten Ausführungsform erfolgt in einem weiteren Schritt (F) des Verfahrens eine Vortrocknung des Vorfixiermittels, so weit vorhanden. Die Vortrocknung kann dazu dienen, in dem Vorfixiermittel enthaltene flüchtige Bestandteile, wie zum Beispiel organische Verbindungen, wenigstens teilweise zu entfernen. Das Vortrocknen kann zum Beispiel bei einer Temperatur im Bereich von 80 - 150°C und beispielsweise für einen Zeitraum von 2 - 30 Minuten erfolgen. Die Vortrocknung hat üblicherweise einen Volumenschwund zur Folge, so dass auch die Dicke der Vorfixierschicht reduziert wird. Die Schritte (E) und (F) können auch zusammenfallen.

Bei dem Verfahren wird eine Substratanordnung mit einer Metallfolie erhalten, deren Oberseite mit einem Kupferbonddraht besonders stabil und mit gleichmäßig hoher Qualität verbunden werden kann.

Die Erfindung stellt ein Verfahren zur Herstellung einer elektronischen Baugruppe bereit.

Das Verfahren umfasst die folgenden Schritte:

(A) Bereitstellung eines Grundsubstrats, das eine Oberseite aufweist, wobei das Grundsubstrat eine Metallschicht umfasst,
(B) Bereitstellung eines Elektronikbauteils, das eine Oberseite und eine Unterseite aufweist,
(C) Bereitstellung einer hierin beschriebenen Substratanordnung,
(D) Kontaktierung der Oberseite des Grundsubstrats mit der Unterseite des Elektronikbauteils unter Ausbildung einer stoffschlüssigen Verbindung und
(E) Kontaktierung der Oberseite des Elektronikbauteils mit der Kontaktierungsschicht der Substratanordnung unter Ausbildung einer stoffschlüssigen Verbindung.

In Schritt (A) des Verfahrens wird ein Grundsubstrat bereitgestellt. Das Grundsubstrat umfasst eine Metallschicht. Ferner weist das Grundsubstrat eine Oberseite auf.

Die Metallschicht des Grundsubstrats kann zum Beispiel Kupfer oder Aluminium umfassen. Vorzugsweise kann die Metallschicht des Grundsubstrats aus einer Metallfolie gebildet sein. Gemäß einer bevorzugten Ausführung umfasst die Metallschicht des Grundsubstrats eine Kupferfolie.

Gemäß einer bevorzugten Ausführungsform besteht das Grundsubstrat aus der Metallschicht.

Gemäß einer anderen bevorzugten Ausführungsform umfasst das Grundsubstrat eine Metallschicht und eine Schicht aus isolierendem Material. Gemäß einer weiteren bevorzugten Ausführungsform umfasst das Grundsubstrat eine Metallschicht und eine Schicht aus isolierendem Material, die stoffschlüssig miteinander verbunden sind. Vorzugsweise umfasst das Grundsubstrat eine Schicht aus isolierendem Material, die auf einer ersten Seite und einer der ersten Seite abgewandten zweiten Seite stoffschlüssig mit einer Metallschicht verbunden ist. Das isolierende Material des Grundsubstrats ist vorzugsweise aus der Gruppe ausgewählt, die aus Glas und Keramik besteht. Die Keramik kann zum Beispiel aus der Gruppe ausgewählt sein, die aus Oxidkeramiken, Nitridkeramiken und Carbidkeramiken besteht.

Gemäß einer bevorzugten Ausführungsform ist das Grundsubstrat aus der Gruppe ausgewählt, die aus Metall-Keramik-Substraten, Printed Circuit Boards (PCBs) und Leadframes besteht. Gemäß einer besonders bevorzugten Ausführungsform handelt es sich bei dem Grundsubstrat um ein fachübliches Metall-Keramik-Substrat. Das Metall-Keramik-Substrat ist vorzugsweise aus der Gruppe ausgewählt, die aus DCB (Direct Copper Bonded)-Substraten und AMB (Active Metal Brazed)-Substraten besteht.

Die Oberseite des Grundsubstrats wird vorzugsweise durch die Metallschicht geschaffen.

In Schritt (B) des Verfahrens wird ein Elektronikbauteil bereitgestellt. Das Elektronikbauteil weist eine Oberseite und eine Unterseite auf.

Bei dem Elektronikbauteil handelt es vorzugsweise um ein wie hierin an anderer Stelle beschriebenes Elektronikbauteil.

In Schritt (C) des Verfahrens wird eine Substratanordnung bereitgestellt.

Bei der Substratanordnung handelt es sich vorzugsweise um eine wie hierin an anderer Stelle beschriebene Substratanordnung.

Die Substratanordnung weist daher vorzugsweise auf

(a) eine Metallfolie, die eine Metallfolienoberseite und eine Metallfolienunterseite umfasst, wobei die Metallfolie eine Kupferschicht umfasst, die eine Kupferschichtoberseite und eine Kupferschichtunterseite aufweist, und wobei die Metallfolienoberseite von der Kupferschichtoberseite gebildet ist, und
(b) eine Kontaktierungsschicht, die auf der Metallfolienunterseite angeordnet ist,

wobei die Kupferschicht die Bedingung

$$K1 / D = 0{,}04 - 0{,}2 \ \mu m^{-1}$$

erfüllt, wobei

D in einem Querschnitt durch die Substratanordnung senkrecht zur Kupferschichtoberseite den Abstand zwischen der Kupferschichtoberseite und der Kupferschichtunterseite angibt, und

K1 die Anzahl an Korngrenzen angibt, die in einem Querschnitt durch die Substratanordnung senkrecht zur Kupferschichtoberseite entlang einer Strecke S1, die in dem Querschnitt senkrecht zur Kupferschichtoberseite von der Kupferschichtoberseite bis zur Kupferschichtunterseite verläuft, vorhanden sind.

In Schritt (D) des Verfahrens wird die Oberseite des Grundsubstrats mit der Unterseite des Elektronikbauteils unter Ausbildung einer stoffschlüssigen Verbindung kontaktiert.

Das Grundsubstrat und das Elektronikbauteil werden hierzu vorzugsweise so positioniert, dass die Unterseite des Elektronikbauteils mit der Oberseite des Grundsubstrats vorzugsweise über ein Kontaktierungsmaterial in Kontakt steht. Bei dem Kontaktierungsmittel kann es sich beispielsweise um eine Sinterpaste, eine Lotpaste oder einen Leitkleber handeln. Der Aufbau umfassend das Grundsubstrat und das Elektronikbauteil wird anschließend einer Behandlung unterzogen, die eine stoffschlüssige Verbindung durch das Kontaktierungsmaterial erlaubt. Dabei wird die Unterseite des Elektronikbauteils auf der Oberseite des Grundsubstrats befestigt. Die Behandlung erfolgt vorzugsweise durch Einbringung von Energie. Die Einbringung von Energie kann vorzugsweise in Form von Temperaturbeaufschlagung und besonders bevorzugt in Form von Temperatur- und Druckbeaufschlagung erfolgen.

In Schritt (E) des Verfahrens wird die Oberseite des Elektronikbauteils mit der Kontaktierungsschicht der Substratanordnung unter Ausbildung einer stoffschlüssigen Verbindung kontaktiert. Dabei erfolgt vorzugsweise die Ausbildung einer stoffschlüssigen Verbindung zwischen der Oberseite des Elektronikbauteils und der Metallfolie der Substratanordnung.

Die Substratanordnung und das Elektronikbauteil werden hierzu vorzugsweise so positioniert, dass die Kontaktierungsschicht der Substratanordnung mit der Oberseite des Elektronikbauteils in Kontakt steht. Der Aufbau umfassend die Substratanordnung und das Elektronikbauteil wird anschließend einer Behandlung unterzogen, die eine stoffschlüssige Verbindung durch die Kontaktierungsschicht erlaubt. Dabei wird die Metallfolie der Substratanordnung auf der Oberseite des Elektronikbauteils befestigt. Die Behandlung erfolgt vorzugsweise durch Einbringung von Energie. Die Einbringung von Energie kann vorzugsweise in Form von Temperaturbeaufschlagung und besonders bevorzugt in Form von Temperatur- und Druckbeaufschlagung erfolgen.

Die Schritte (D) und (E) können in einem Fertigungsschritt oder in unterschiedlichen Fertigungsschritten durchgeführt werden. Dabei können die Schritte (D) und (E) sequenziell oder gleichzeitig durchgeführt werden.

Sofern die Schritte (D) und (E) sequenziell durchgeführt werden, kann Schritt (D) zeitlich vor Schritt (E) erfolgen. Andererseits ist es auch möglich, dass Schritt (E) vor Schritt (D) erfolgt.

Sofern die Schritte (D) und (E) sequenziell durchgeführt werden, kann gemäß einer ersten Ausführungsform in Schritt (D) das Elektronikbauteil Teil einer ersten Anordnung sein, die das Elektronikbauteil und die Metallfolie der Substratanordnung umfasst. In diesem Fall kann zunächst in Schritt (E) eine erste Anordnung, die das Elektronikbauteil und die Metallfolie der Substratanordnung umfasst, hergestellt werden, indem die Oberseite des Elektronikbauteils mit der Metallfolie der Substratanordnung unter Ausbildung einer stoffschlüssigen Verbindung zwischen der Oberseite des Elektronikbauteils und der Metallfolie der Substratanordnung kontaktiert wird. Diese erste Anordnung kann anschließend in Schritt (D) mit dem Grundsubstrat kontaktiert werden, so dass die Unterseite des Elektronikbauteils als Teil der ersten Anordnung mit der Oberseite des Grundsubstrats stoffschlüssig verbunden wird.

Sofern die Schritte (D) und (E) sequenziell durchgeführt werden, kann gemäß einer zweiten Ausführungsform in Schritt (E) das Elektronikbauteil Teil einer zweiten Anordnung sein, die das Grundsubstrat und das Elektronikbauteil umfasst. In diesem Fall kann zunächst in Schritt (D) eine zweite Anordnung, die das Grundsubstrat und das Elektronikbauteil umfasst, hergestellt werden. Diese zweite Anordnung kann anschließend in Schritt (E) mit der Substratanordnung kontaktiert werden, so dass die Metallfolie der Substratanordnung mit der Oberseite des Elektronikbauteils als Teil der zweiten Anordnung stoffschlüssig verbunden wird.

Durch die stoffschlüssige Verbindung von Grundsubstrat, Elektronikbauteil und Metallfolie der Substratanordnung wird eine elektronische Baugruppe erhalten.

Gemäß einer bevorzugten Ausführungsform erfolgt in einem weiteren Schritt (F) die elektrische Kontaktierung eines Bereichs auf der Oberseite der Metallfolie mit einem Bereich auf der Oberseite des Grundsubstrats. Die elektrische Kontaktierung erfolgt vorzugsweise durch Drahtbonden. Für das Drahtbonden wird vorzugsweise ein Bonddraht verwendet. Der Begriff Bonddraht umfasst zum Bonden geeignete Drähte vorzugsweise unabhängig von deren Durchmesser beziehungsweise Dicke und besonders bevorzugt unabhängig von deren Querschnittsgeometrie (so zum Beispiel auch Bondbänder). Der Bonddraht umfasst vorzugsweise Kupfer. Gemäß einer bevorzugten Ausführungsform ist der Bonddraht aus einem Material beschaffen, das aus der Gruppe ausgewählt ist, die aus Kupfer und Kupferlegierungen besteht.

**Figurenbeschreibung:**

Weitere Merkmale und Vorteile der Erfindung ergeben sich aus der nachfolgenden Figurenbeschreibung, in der bevorzugte Ausführungsformen der Erfindung anhand von schematischen Zeichnungen erläutert sind.
Dabei zeigen:

Figur 1    die Seitenansicht einer erfindungsgemäßen Substratanordnung und
Figur 2    die Seitenansicht einer elektronischen Baugruppe, die unter Verwendung der erfindungsgemäßen Substratanordnung erhalten wird.

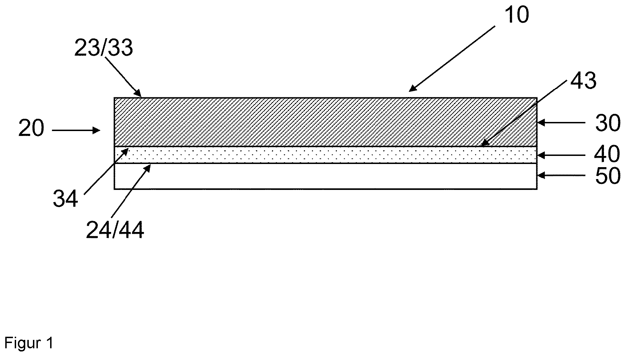

Figur 1 zeigt - nicht maßstabsgetreu - eine erfindungsgemäße Substratanordnung 10, die eine Metallfolie 20 und eine Kontaktierungsschicht 50 umfasst. Die Metallfolie 20 umfasst eine Metallfolienoberseite 23 und eine Metallfolienunterseite 24 Die Metallfolie 20 ist aus einer Kupferschicht 30 und einer Haftvermittlungsschicht 40 gebildet. Die Kupferschicht 30 weist eine Kupferschichtoberseite 33 und eine Kupferschichtunterseite 34 auf. Die Kupferschicht 30 erfüllt die Bedingung $K1 / D = 0{,}04 - 0{,}2 \ \mu m^{-1}$, wobei D in einem Querschnitt durch die Substratanordnung senkrecht zur Kupferschichtoberseite den Abstand zwischen der Kupferschichtoberseite und der Kupferschichtunterseite angibt, und K1 die Anzahl an Korngrenzen angibt, die in einem Querschnitt durch die Substratanordnung senkrecht zur Kupferschichtoberseite entlang einer Strecke S1, die in dem Querschnitt senkrecht zur Kupferschichtoberseite von der Kupferschichtoberseite bis zur Kupferschichtunterseite verläuft, vorhanden sind. Die Haftvermittlungsschicht 40 weist eine Haftvermittlungsschichtoberseite 43 und eine Haftvermittlungsschichtunterseite 44 auf. Die Haftvermittlungsschichtoberseite 43 ist mit der Kupferschichtunterseite 34 stoffschlüssig verbunden. Die Metallfolienoberseite 23 ist von der Kupferschichtoberseite 33 gebildet. Die Metallfolienunterseite 24 ist von der Haftvermittlungsschichtunterseite 44 gebildet. Die Kontaktierungsschicht 50 ist auf der Metallfolienunterseite 24 beziehungsweise der Haftvermittlungsschichtunterseite 44 angeordnet.

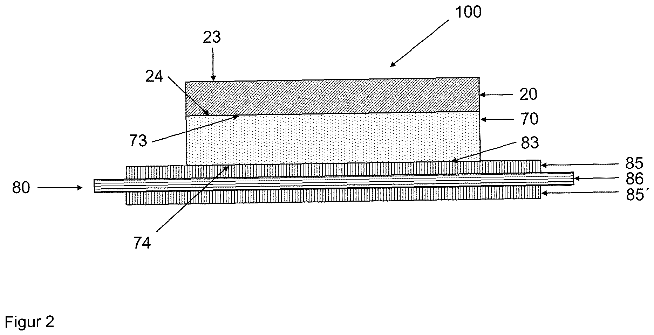

Figur 2 zeigt eine elektronische Baugruppe 100, die durch das erfindungsgemäße Verfahren hergestellt werden kann. Die elektronische Baugruppe 100 umfasst eine Metallfolie 20, ein Elektronikbauteil 70 und ein Grundsubstrat 80. Das Grundsubstrat 80 weist eine Schicht aus isolierendem Material 86 auf, die beidseitig mit einer Metallschicht 85, 85' flächig verbunden ist. Bei dem Grundsubstrat 80 handelt es sich typischerweise um ein Metall-Keramik-Substrat. Die Oberseite 83 des Grundsubstrats 80 wird durch die Metallschicht 85 geschaffen. Auf der Oberseite 83 des Grundsubstrats 80 ist ein Elektronikbauteil 70 angeordnet, das eine Oberseite 73 und eine Unterseite 74 aufweist. Die Unterseite 74 des Elektronikbauteils 70 ist auf der Oberseite 83 des Grundsubstrats 80 angeordnet. Das Elektronikbauteil 70 ist mit dem Grundsubstrat 80 flächig verbunden. Hierzu kann das Elektronikbauteil 70 zum Beispiel unter Verwendung einer Sinterpaste auf dem Grundsubstrat 80 befestigt sein. Zwischen der Oberseite 83 des Grundsubstrats 80 und der Unterseite 74 des Elektronikbauteils 70 kann sich daher eine Verbindungszone befinden (nicht gezeigt). Das Elektronikbauteil 70 ist mit einer Metallfolie 20 über eine Verbindungszone (nicht gezeigt) verbunden. Die Metallfolie 20 weist eine Metallfolienoberseite 23 und eine Metallfolienunterseite 24 auf. Die Metallfolienunterseite 24 ist auf der Oberseite 73 des Elektronikbauteils 70 angeordnet. Die Metallfolie 20 ist auf dem Elektronikbauteil 70 befestigt. Die Befestigung kann erfolgen, indem zunächst eine Substratanordnung (wie in Figur 1 gezeigt), die die Metallfolie 20 und eine Kontaktierungsschicht umfasst, auf der Oberseite 73 des Elektronikbauteils 70 so positioniert wird, dass die Kontaktierungsschicht mit der Oberseite 73 des Elektronikbauteils 70 in Kontakt steht. Anschließend wird der so erhaltene Aufbau Bedingungen ausgesetzt, die die Ausbildung einer stoffschlüssigen Verbindung zwischen der Metallfolie 20 und dem Elektronikbauteil 70 ermöglichen. Die Kontaktierungsschicht kann beispielsweise aus einer vorgetrockneten Sinterpaste bestehen. In diesem Fall wird der Aufbau zum Beispiel mit Temperatur und Druck beaufschlagt, um die Ausbildung einer Sinterverbindung zwischen der Metallfolie 20 und dem Elektronikbauteil 70 zu ermöglichen. Bei der Ausbildung der Sinterverbindung wird zwischen der Metallfolie 20 und dem Elektronikbauteil 70 durch die Kontaktierungsschicht eine Verbindungszone geschaffen (nicht gezeigt). Die Metallfolienoberseite kann mit unbestückten Bereichen auf der Oberseite 83 des Grundsubstrats 80 mit einem Bonddraht kontaktiert werden (nicht gezeigt). Die Metallfolienoberseite kann außerdem mit einer weiteren Komponente, insbesondere unter Verwendung eines Sintermaterials, stoffschlüssig verbunden werden (nicht gezeigt).

**Beispiele:**

Die vorliegende Erfindung wird nachstehend anhand von Beispielen veranschaulicht, die jedoch nicht als einschränkend zu verstehen sind.

## 1. Herstellung von Substratanordnungen

Zur Herstellung einer Substratanordnung gemäß den Beispielen und den Vergleichsbeispielen wurden Kupferfolien gleicher Beschaffenheit mit einer Dicke von 50 $\mu$m verwendet. Diese Kupferfolien wurden mittels fotolithografischem Ätzen unter Verwendung einer geeigneten Maskierung mit einer Eisenchlorid ($FeCl_3$)-Ätzlösung in Kupferfolienstücke der Abmaße 7,6 mm x 7,6 mm strukturiert, wobei die einzelnen Kupferfolienstücke noch über Stege miteinander verbunden waren. Die Maskierung wurde anschließend entfernt.

*Beispiel 1:*

Die Kupferfolienstücke wurden im Batchofen bei einer Temperatur von 450°C wärmebehandelt. Hierzu wurde die Glühkammer nach dem Einbringen der Kupferfolienstücke zunächst mit Prozessgas (Gemisch aus 5 % Wasserstoff und 95 % Stickstoff) gespült. Diese Prozessgasbehandlung erfolgte für eine Dauer von 30 min bei einem Gasfluss von 16 l / min (Restsauerstoffgehalt $\leq$ 0,2%). Anschließend wurde der Ofen mit einer Heizrate von 1 °C/min aufgeheizt, bis eine Temperatur von 450°C erreicht war. Nach 180 min Behandlungsdauer wurde der Ofen ausgeschaltet und abkühlen gelassen. Nach dem Erreichen von Raumtemperatur wurde der Gasfluss gestoppt und die Kupferfolienstücke wurden entnommen.

Die Kupferfolienstücke wurden sodann auf eine Transferfolie (Chip-Sägefolie) in einem Kunststoffrahmen aufgebracht und mit einer 400 nm dicken galvanischen Silberschicht metallisiert. Anschließend wurde auf diese Silberschicht eine Silbersinterschicht aufgebracht. Hierzu wurde auf einen Bereich von 7,1 mm x 7,1 mm eine Sinterpaste (ASP 043-60, Heraeus) mittels Schablonendrucks aufgebracht (Nassschichtdicke = 40 $\mu$m). Außer dem mit Sinterpaste versehenen Bereich wies die Beschichtung einen umlaufenden, von Sinterpaste freien Randbereich von 0,25 mm Breite auf. Die so mit einer Sinterpaste auf der Beschichtung versehenen Kupferfolienstücke wurden anschließend an Luftatmosphäre für zehn Minuten bei 110°C getrocknet, vom Rahmen entfernt, von der Transferfolie gelöst und unter Trennung der Stege mittels Laser vereinzelt, wobei Substratanordnungen erhalten wurden, die eine Metallfolie umfassend eine Metallfolienoberseite und eine Metallfolienunterseite, sowie eine Kontaktierungsschicht aufwiesen, wobei die Kontaktierungsschicht auf der Metallfolienunterseite angeordnet war.

*Beispiel 2:*

Beispiel 2 wurde analog zu Beispiel 1 durchgeführt, wobei die Kupferfolienstücke einer Wärmebehandlung bei einer Temperatur von 300°C für 60 min unterzogen wurden.

*Vergleichsbeispiel 1:*

Vergleichsbeispiel 1 wurde analog zu Beispiel 1 durchgeführt, wobei die Kupferfolienstücke einer Wärmebehandlung bei einer Temperatur von 250°C für 60 min unterzogen wurden.

*Vergleichsbeispiel 2:*

Vergleichsbeispiel 2 wurde analog zu Beispiel 1, jedoch ohne Wärmebehandlung durchgeführt.

## 2. Herstellung von elektronischen Baugruppen

Zur Herstellung von elektronischen Baugruppen wurden zunächst Anordnungen aus je einem Grundsubstrat und je einem Elektronikbauteil geschaffen. Als Grundsubstrat wurde ein kommerziell erhältliches direktmetallisiertes Kupfer-Keramik-Substrat (DCB; Condura® classic, Heraeus) und als Elektronikbauteil ein Siliziumchip mit der Abmessung 8,8 mm x 8,8 mm (Dicke = 70 $\mu$m), der eine unterseitige Metallisierung (NiP/Pd) sowie eine oberseitige Metallisierung (NiP/Pd) aufwies, verwendet.

Auf die Oberseite der Kupfer-Keramik-Substrate wurde eine Sinterpaste (ASP 338-28, Heraeus) mittels Schablonendrucks aufgebracht (Nassschichtdicke = 100 $\mu$m). Die mit Sinterpaste versehenen Kupfer-Keramik-Substrate wurden an Luftatmosphäre für zehn Minuten bei 100°C getrocknet und anschließend abgekühlt. Auf den vorgetrockneten Sinterpasten wurde je ein Siliziumchip positioniert, so dass die Unterseite der Siliziumchips mit der Oberseite des jeweiligen Kupfer-Keramik-Substrats in Kontakt stand.

Anschließend wurden die jeweiligen Substratanordnungen gemäß den Beispielen 1 und 2 sowie den Vergleichsbeispielen 1 und 2 jeweils auf der Oberseite eines Siliziumchips positioniert, so dass die Silbersinterschicht der jeweiligen Substratanordnung mit der Oberseite des Siliziumchips in Kontakt stand.

Sodann wurde der jeweilig erhaltene Aufbau gesintert. Das Sintern erfolgte in einer Sinterpresse (Fa. Pink, Wertheim) für eine Dauer von drei Minuten in einer Stickstoffatmosphäre bei einem Druck von 20 MPa und einer Temperatur von 250°C. Dabei wurden elektronische Baugruppen erhalten, die jeweils mit Metallfolien aus den Substratanordnungen gemäß den Beispielen 1 und 2 bzw. mit Metallfolien aus den Substratanordnungen gemäß den Vergleichsbeispielen 1 und 2 ausgestattet waren.

Anschließend erfolgte das Bonden eines Kupferbonddrahtes mit einem Durchmesser von 400 $\mu$m (Power Cu Soft, Heraeus) auf die Oberseite der Metallfolie der hergestellten elektronischen Baugruppen. Hierzu wurde der Kupferbonddraht in einem Wedge-Wedge-Bondverfahren mit einem Wedge-Bonder (Asterion Orthodyne Bonder, Kulicke & Soffa) bei einer Frequenz von 80 kHz auf die Oberseite der Metallfolie der elektronischen Baugruppe gebondet.

3. Auswertung

Die in den Beispielen 1 und 2 sowie den Vergleichsbeispielen 1 und 2 hergestellten elektronischen Baugruppen wurden daraufhin untersucht, ob die Verbindung zwischen der Unterseite der Metallfolie und der Oberseite des Elektronikbauteils starken Temperaturwechseln unter Strombelastung dauerhaft standhalten kann. Hierzu wurden Lastwechseltests durchgeführt. Für die Lastwechseltests wurden die elektronischen Baugruppen jeweils auf einen Kühlkörper gelötet und direkt gekühlt. Die elektronischen Baugruppen wurden dann mit Lastwechseln beaufschlagt. Hierzu wurden die elektronischen Baugruppen mit Laststrom einer Stärke von 190 A beaufschlagt, wodurch sich die elektronischen Baugruppen erwärmten. Sobald die Oberseite des Elektronikbauteils eine Temperatur von 170° erreicht hatte, wurde der Laststrom ausgeschaltet, so dass sich die elektronische Baugruppe abkühlen konnte. Sobald die Oberseite des Elektronikbauteils eine Temperatur von 40° erreicht hatte, wurde der Laststrom wieder eingeschaltet. Dieser Zyklus wurde so lange wiederholt, bis die getesteten elektronischen Baugruppe ausfielen. Ein Ausfall lag vor, wenn wenigstens eines der folgenden Kriterien erfüllt war: (1) Anstieg der Vorwärtsspannung ($V_{ce}$) um 5 %, (2) Anstieg des Wärmewiderstands ($R_{th}$) um 20 % und (3) Überschreiten der Chiptemperatur von 200 °C.

Die Ergebnisse sind in Tabelle 1 dargestellt.

Tabelle 1: Ergebnisse der Untersuchung der mit den Substratanordnungen der Beispiele 1 und 2 sowie der Vergleichsbeispiele 1 und 2 hergestellten elektronischen Baugruppen mittels Lastwechseltest.

|  | K1/D ($\mu$m$^{-1}$) | K1/K2 | Ergebnis Lastwechseltest (Zyklen bis Ausfall) |
|---|---|---|---|
| Beispiel 1 | 0,08 | 0,7 | 1,8E+6 |
| Beispiel 2 | 0,16 | 1,6 | 1,3E+6 |
| Vergleichsbeispiel 1 | 0,22 | 2,8 | 0,9E+6 |
| Vergleichsbeispiel 2 | 0,3 | 2,1 | 0,8E+6 |

4 Beurteilung

Die Ergebnisse zeigen, dass die erfindungsgemäßen Substratanordnungen der Beispiele 1 und 2 Metallfolien aufwiesen, deren Unterseite mit der Oberseite eines Elektronikbauteils eine Verbindung eingehen konnte, die starken Temperaturwechseln unter Strombelastung dauerhaft standhielt. Diese Verbindung erwies sich in Lastwechseltests stabiler als eine Verbindung, die mit den Substratanordnungen der Vergleichsbeispiele 1 und 2 erhalten wurde.

**Bezugszeichenliste:**

| 10 | Substratanordnung |
|---|---|
| 20 | Metallfolie |
| 23 | Metallfolienoberseite |
| 24 | Metallfolienunterseite |
| 30 | Kupferschicht |
| 33 | Kupferschichtoberseite |

| 34 | Kupferschichtunterseite |
| 40 | Haftvermittlungsschicht |
| 43 | Haftvermittlungsschichtoberseite |
| 44 | Haftvermittlungsschichtunterseite |
| 50 | Kontaktierungsschicht |
| 70 | Elektronikbauteil |
| 73 | Oberseite (Elektronikbauteil) |
| 74 | Unterseite (Elektronikbauteil) |
| 80 | Grundsubstrat |
| 83 | Oberseite (Grundsubstrat) |
| 85, 85' | Metallschicht |
| 86 | Schicht aus isolierendem Material |
| 100 | Elektronische Baugruppe |

**Patentansprüche**

1. Substratanordnung aufweisend

    (a) eine Metallfolie, die eine Metallfolienoberseite und eine Metallfolienunterseite umfasst,

    wobei die Metallfolie eine Kupferschicht umfasst, die eine Kupferschichtoberseite und eine Kupferschichtunterseite aufweist, und
    wobei die Metallfolienoberseite von der Kupferschichtoberseite gebildet ist, und

    (b) eine Kontaktierungsschicht, die auf der Metallfolienunterseite angeordnet ist, **dadurch gekennzeichnet, dass** die Kupferschicht die Bedingung

$$K1 / D = 0{,}04 - 0{,}2 \ \mu m^{-1}$$

    erfüllt, wobei

    D in einem Querschnitt durch die Substratanordnung senkrecht zur Kupferschichtoberseite den Abstand zwischen der Kupferschichtoberseite und der Kupferschichtunterseite angibt, und
    K1 die Anzahl an Korngrenzen angibt, die in einem Querschnitt durch die Substratanordnung senkrecht zur Kupferschichtoberseite entlang einer Strecke S1, die in dem Querschnitt senkrecht zur Kupferschichtoberseite von der Kupferschichtoberseite bis zur Kupferschichtunterseite verläuft, vorhanden sind.

2. Substratanordnung nach Anspruch 1, **dadurch gekennzeichnet, dass** die Kupferschicht die Bedingung

$$K1 / K2 = 0{,}5 - 2{,}0$$

    erfüllt,

    wobei K2 die Anzahl an Korngrenzen angibt, die in dem Querschnitt entlang einer Strecke S2 vorhanden sind, und
    wobei die Strecken S1 und S2 dieselbe Länge aufweisen, die Strecken S1 und S2 zueinander senkrecht verlaufen und die Strecke S2 die Strecke S1 auf halber Länge schneidet.

3. Substratanordnung nach Anspruch 1 oder 2, **dadurch gekennzeichnet, dass** die Metallfolie eine Haftvermittlungsschicht umfasst, die eine Haftvermittlungsschichtoberseite und eine Haftvermittlungsschichtunterseite aufweist, wobei die Haftvermittlungsschichtoberseite mit der Kupferschichtunterseite stoffschlüssig verbunden ist.

4. Substratanordnung nach Anspruch 3, **dadurch gekennzeichnet, dass** die Haftvermittlungsschicht mehrlagig ausgestaltet ist.

5. Substratanordnung nach einem der vorangegangenen Ansprüche, **dadurch gekennzeichnet, dass** die Kontaktierungsschicht ein Kontaktierungsmittel umfasst.

6. Substratanordnung nach Anspruch 5, **dadurch gekennzeichnet, dass** das Kontaktierungsmittel wenigstens ein Mitglied umfasst, das aus der Gruppe ausgewählt ist, die aus Silber und Kupfer besteht.

7. Substratanordnung nach Anspruch 5 oder 6, **dadurch gekennzeichnet, dass** das Kontaktierungsmittel ein Sintermaterial umfasst.

8. Substratanordnung nach Anspruch 7, **dadurch gekennzeichnet, dass** die Kontaktierungsschicht eine vorgetrocknete Sinterpaste umfasst.

9. Verfahren zur Herstellung einer elektronischen Baugruppe umfassend die Schritte

(A) Bereitstellung eines Grundsubstrats, das eine Oberseite aufweist, wobei das Grundsubstrat eine Metallschicht umfasst,
(B) Bereitstellung eines Elektronikbauteils, das eine Oberseite und eine Unterseite aufweist, und
(C) Bereitstellung einer Substratanordnung gemäß einem der vorangegangenen Ansprüche,
(D) Kontaktierung der Oberseite des Grundsubstrats mit der Unterseite des Elektronikbauteils unter Ausbildung einer stoffschlüssigen Verbindung und
(E) Kontaktierung der Oberseite des Elektronikbauteils mit der Kontaktierungsschicht der Substratanordnung unter Ausbildung einer stoffschlüssigen Verbindung.

10. Elektronische Baugruppe herstellbar durch ein Verfahren gemäß Anspruch 9.

Figur 1

Figur 2

**EP 4 787 433 A1**

Europäisches Patentamt
European Patent Office
Office européen des brevets

# EUROPÄISCHER RECHERCHENBERICHT

Nummer der Anmeldung

EP 25 15 5319

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | WO 2009/081889 A1 (NIPPON MINING CO [JP]; OKANO TOMOKI [JP] ET AL.) 2. Juli 2009 (2009-07-02) * Zusammenfassung *; Anspruch 1; Abbildung 3 * | 1-10 | INV. H01L23/00 B32B15/20 H01L23/373 |
| A | EP 4 443 488 A1 (HERAEUS ELECTRONICS GMBH & CO KG [DE]) 9. Oktober 2024 (2024-10-09) * Zusammenfassung *; Ansprüche; Abbildung 3 * | 1-10 | |
| A | JP 2009 111203 A (NIKKO KINZOKU KK) 21. Mai 2009 (2009-05-21) * Zusammenfassung *; Ansprüche; Abbildungen * * Absätze [0014], [0033] * | 1-10 | |
| A | WO 2023/054398 A1 (MITSUI MINING & SMELTING CO LTD [JP]) 6. April 2023 (2023-04-06) * Zusammenfassung *; Anspruch 1; Abbildungen * | 1-10 | |
| A | LI XIN ET AL: "Effect of Oxygen Content on Bonding Performance of Sintered Silver Joint on Bare Copper Substrate", IEEE TRANSACTIONS ON COMPONENTS, PACKAGING AND MANUFACTURING TECHNOLOGY, IEEE, USA, Bd. 13, Nr. 3, 4. April 2023 (2023-04-04), Seiten 391-398, XP011939901, ISSN: 2156-3950, DOI: 10.1109/TCPMT.2023.3264487 [gefunden am 2023-04-05] * Zusammenfassung * * * Seite 394, rechte Spalte, Zeile vorletzte * | 1-10 | RECHERCHIERTE SACHGEBIETE (IPC) H01L B32B |

Der vorliegende Recherchenbericht wurde für alle Patentansprüche erstellt

| Recherchenort | Abschlußdatum der Recherche | Prüfer |
|---|---|---|
| Den Haag | 16. Juli 2025 | Wirner, Christoph |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
......................................................................
& : Mitglied der gleichen Patentfamilie, übereinstimmendes Dokument

EPO FORM 1503 03.82 (P04C03)

19

**ANHANG ZUM EUROPÄISCHEN RECHERCHENBERICHT
ÜBER DIE EUROPÄISCHE PATENTANMELDUNG NR.**　　EP 25 15 5319

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-07-2025

| Im Recherchenbericht angeführtes Patentdokument | Datum der Veröffentlichung | Mitglied(er) der Patentfamilie | Datum der Veröffentlichung |
|---|---|---|---|
| WO 2009081889 A1 | 02-07-2009 | CN 101904228 A | 01-12-2010 |
| | | JP 4961023 B2 | 27-06-2012 |
| | | JP WO2009081889 A1 | 06-05-2011 |
| | | KR 20100076055 A | 05-07-2010 |
| | | TW 200934339 A | 01-08-2009 |
| | | WO 2009081889 A1 | 02-07-2009 |
| EP 4443488 A1 | 09-10-2024 | EP 4443488 A1 | 09-10-2024 |
| | | TW 202441746 A | 16-10-2024 |
| | | WO 2024208808 A1 | 10-10-2024 |
| JP 2009111203 A | 21-05-2009 | JP 5057932 B2 | 24-10-2012 |
| | | JP 2009111203 A | 21-05-2009 |
| WO 2023054398 A1 | 06-04-2023 | CN 118019880 A | 10-05-2024 |
| | | JP WO2023054398 A1 | 06-04-2023 |
| | | KR 20240067875 A | 17-05-2024 |
| | | TW 202323594 A | 16-06-2023 |
| | | WO 2023054398 A1 | 06-04-2023 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

**In der Beschreibung aufgeführte Patentdokumente**

- EP 3154729 A1
- EP 2428293 A2
- EP 3940758 A2